Europäisches Patentamt

European Patent Office

Office européen des brevets

(19)

(11) Publication number: **0 202 727 B1**

# EUROPEAN PATENT SPECIFICATION

(12)

(45) Date of publication of patent specification: **08.01.92**

(51) Int. Cl.⁵: **H01L 21/00,** H01L 21/28, H01L 29/08, H01L 29/10

(21) Application number: **86300865.2**

(22) Date of filing: **10.02.86**

(54) Semiconductor devices.

(30) Priority: **23.03.85 GB 8507602**

(43) Date of publication of application:
**26.11.86 Bulletin 86/48**

(45) Publication of the grant of the patent:
**08.01.92 Bulletin 92/02**

(84) Designated Contracting States:
**DE FR IT NL**

(56) References cited:
**EP-A- 0 034 341**
**EP-A- 0 036 620**
**EP-A- 0 122 004**
**FR-A- 2 358 750**

**IEEE INTERNATIONAL SOLID-STATE CIR-
CUITS CONFERENCE, vol. 24, February 1981,
pages 216-217, IEEE, New York, US; T. SAKAI
et al.: "A 3ns 1Kb RAM using super self-
aligned process technology"**

**PATENT ABSTRACTS OF JAPAN, vol. 5, no.
159 (E-77)[831], 14th October 1981; & JP-A-56
90 561**

(73) Proprietor: **Northern Telecom Europe Limited
1B Portland Place
London, W1N 3AA(GB)**

(72) Inventor: **Scovell, Peter Denis
14 Staplecroft
Spring Field Chelmsford Essex(GB)**
Inventor: **Baker, Roger Leslie
7 Third Avenue
Chelmsford Essex(GB)**
Inventor: **Blomley, Peter Fred
2 Oakleigh Court Maple Avenue
Bishops Stortford Hertfordshire(GB)**
Inventor: **Tomkins, Gary John
41 Edna Road
Maidstone Kent(GB)**

(74) Representative: **Dennis, Mark Charles et al
Northern Telecom Europe Limited West
Road
Harlow Essex CM20 2SH(GB)**

Rank Xerox (UK) Business Services

## Description

This invention relates to semiconductor devices and in particular bipolar transistors with polycrystalline silicon emitters, and methods of manufacturing them.

The use of a polycrystalline silicon emitter offers improved performance for bipolar transistors. Several methods of self-aligning this type of device have been published, for example Tang D., IEEE JSSC SC17 1983 P.226 and Sakai T., IEEE IEDM Techn. Dig. 1983 p.16. These methods rely on the use of polysilicon (polycrystalline silicon) base contacts (electrodes) and two layers of polysilicon are actually employed. Another process which can employ two layers of polysilicon is described in IEEE Int. Solid-State Circuit Conference Vol 24 (1981) pp 216-217; T Sakai et al, the first or only layer of polysilicon providing polysilicon base contacts (electrodes).

According to the present invention there is provided a method of manufacturing a bipolar transistor which requires the provision of only a single layer of polycrystalline silicon, comprising performing the following steps in the following order, implanting dopant of one conductivity type into a semiconductor substrate of the other conductivity type through an oxide layer disposed thereon via a window in a masking layer whereby to provide a base region in the substrate, subsequently removing at least part of the exposed oxide layer and removing the masking layer, depositing a polycrystalline silicon layer comprising said single layer on the base region and the surrounding oxide layer, doping said polycrystalline silicon layer the other conductivity type, defining a mesa from the doped polycrystalline silicon layer, which mesa overlies a portion of the base region, and which mesa comprises a polycrystalline silicon emitter for the bipolar transistor, performing an oxidation process during which at least the side walls of the mesa are oxidised, implanting dopant of the one conductivity type into the substrate, whereby to provide a base contact region therein in contact with the base region, using at least one oxidised side wall of the mesa as part of the implantation mask, whereby the base contact region is self-aligned with the polycrystalline silicon emitter, forming a collector contact region of the other conductivity type in the substrate, and providing external electrical contacts to the implanted base contact region, the collector contact region and the polycrystalline silicon emitter.

Embodiments of the present invention will now be described with reference to the accompanying drawings, in which:

Figs. 1 to 6 illustrate, schematically and in cross-section, successive processing stages in the manufacture of self-aligned base contact regions according to one embodiment of the present invention, and

Fig. 7 illustrates a cross-section through a fully self-aligned polysilicon emitter bipolar transistor.

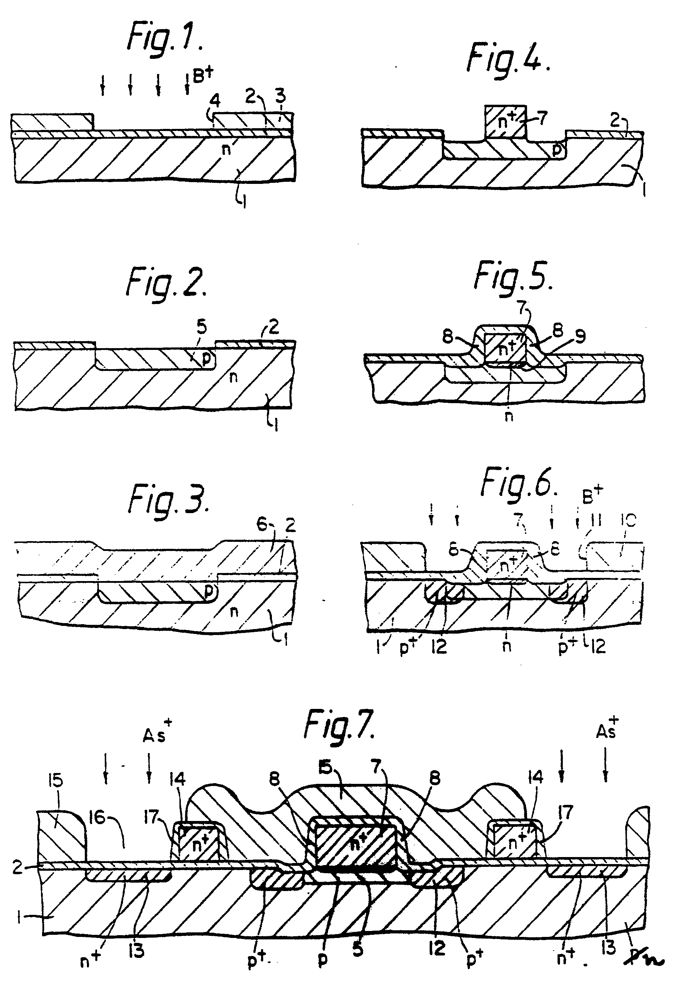

Referring firstly to Figs. 1 to 6 the successive processing stages required to manufacture self-aligned base contact regions in a substrate will be described. A substrate 1 of n-type single crystal silicon is oxidised to provide a surface layer of silicon dioxide 2. A layer of photoresist 3 is applied and using a suitable mask (not shown) a window 4 is opened in the photoresist 3, which window 4 defines the base area (Fig. 1). Using ion implantation boron, for example, is implanted to produce a base region 5. Following this implantation the oxide exposed through window 4 is etched using the base mask (photoresist 3) to define the area within which the emitter will be formed. The photoresist 3 is removed (Fig. 2). If a surface treatment is required to produce an interfacial oxide it can be used now. A layer of polysilicon 6 is then deposited (Fig. 3) and doped $n^+$, for example with arsenic or phosphorus. Following definition of the emitter area the polysilicon 6 is dry etched to produce the structure of Fig. 4 with a substantially central $n^+$ polysilicon mesa or emitter 7. The dry etch is controlled to give good anisotropy and high selectivity over the single crystal silicon substrate 1. We have demonstrated a selectivity of 10:1. For typical layer thickness and overetches this would lead to less than 500A (0.05 $\mu$m) of the base region being consumed during the polysilicon etch process. The structure is then provided with oxide sidewall spacers 8 (Fig. 5). The spacers may be produced by, for example the oxidation method described in our co-pending Application No. GB-8507600 (serial No. 2172743) or by using reactive ion etching (RIE) of a conformed deposited oxide. The method described in our co-pending Application involves the use of a silicon nitride capping layer on a polysilicon mesa (emitter) and oxidising the sidewalls of the mesa at a low temperature which is preferably below 900°C in order to take full advantage of the differential oxidation ration of polysilicon and single crystal silicon. As a result of this processing an n type region 9 is formed. The structure is then provided with a photoresist layer 10 (Fig. 6) which is patterned using a suitable mask (not shown) to provide a window 11 therein, that is to define a $p^+$ contact mask. A base contact region implant of, for example, boron is performed to produce base contact regions 12 in the substrate which are self-aligned with the polysilicon emitter 7 by virtue of using the polysilicon and sidewall spacers 8 as a part of the $p^+$ contact region mask. To complete a bipolar transistor from the structure of Fig. 6 a collector contact region (not shown) in the substrate 1 is required together with suitable metallisation, for example, to provide external electrical contacts to the base and collector contacts regions, and to the polysilicon emitter.

A section through a complete bipolar transistor is shown in Fig. 7. This transistor has collector contact regions 13 in the substrate which are aligned to the emitter edges by use of polysilicon stripes (alignment mesas) 14 defined in the same masking and etching sequence as the emitter mesa 7. The sidewalls 17 of the stripes 14 are also oxidised as those of the emitter 7. A photoresist layer 15 is applied and patterned using a mask not shown to provide windows 16 for implantation of arsenic, for example, for the collector contact regions 13. The mask need only be a "sloppy" mask since the outermost oxidised edges of the stripes 14 define the edge of the collector contact regions and photoresist is only required to protect areas into which collector contact material is not to be implanted. The edge of the polysilicon stripe defines the distance between the emitter edge and the collector contact region. The device is thus fully self-aligned.

The self-alignment of the base contact regions is thus achieved by a method which uses a single layer of polysilicon and sidewalls and is simplified in comparison with the known methods, which may use two layers of polysilicon, referred to above.

## Claims

1. A method of manufacturing a bipolar transistor which requires the provision of only a single layer of polycrystalline silicon, comprising performing the following steps in the following order, implanting dopant of one conductivity type into a semiconductor substrate (1) of the other conductivity type through an oxide layer (2) disposed thereon via a window (4) in a masking layer (3) whereby to provide a base region (5) in the substrate, subsequently removing at least part of the exposed oxide layer (2) and removing the masking layer (3), depositing a polycrystalline silicon layer (6) comprising said single layer on the base region (5) and the surrounding oxide layer (2), doping said polycrystalline silicon layer (6) the other conductivity type, defining a mesa (7) from the doped polycrystalline silicon layer (6), which mesa (7) overlies a portion of the base region, and which mesa comprises a polycrystalline silicon emitter for the bipolar transistor, performing an oxidation process during which at least the side walls (8) of the mesa (7) are oxidised, implanting dopant of the one conductivity type into the substrate (1), whereby to provide a base contact region (12) therein in contact with the base region (5), using at least one oxidised side wall (8) of the mesa as part of the implantation mask, whereby the base contact region (12) is self-aligned with the polycrystalline silicon emitter (7), forming a collector contact region (13) of the other conductivity type in the substrate (1), and providing external electrical contacts to the implanted base contact region (12), the collector contact region (13) and the polycrystalline silicon emitter (7).

2. A method as claimed in claim 1, wherein the mesa definition comprises appropriately masking the polycrystalline silicon layer (6) and dry etching.

3. A method as claimed in claim 1 or claim 2, further including the steps of defining at least one polycrystalline silicon contact alignment mesa (14) from said polycrystalline silicon layer (6), which alignment mesa (14) is disposed on the oxide layer (2) and the sidewalls (17) of which alignment mesa (14) are oxidised during said oxidation process, and implanting the collector contact region (13) into the substrate (1) using at least one oxidised side wall (17) of the alignment mesa (14) as part of the implantation mask whereby the spacing between the polycrystalline silicon emitter (7) and the collector contact region (13) is defined by the alignment mesa (14).

4. A method as claimed in any one of the preceding claims wherein the mesa (7) is disposed substantially centrally with respect to a surface of the base region (5) and including the step of forming two said base contact region (12) on opposite sides of the mesa (7) and self-aligned therewith by respective oxidised side walls (8).

5. A method as claimed in any one of the preceding claims wherein another part of the base contact region implantation mask is provided by photoresist (10).

## Revendications

1. Procédé de fabrication d'un transistor bipolaire qui nécessite la disposition d'une seule couche de silicium polycristallin, comprenant l'exécution des étapes suivantes, dans l'ordre suivant : l'implantation d'une matière de dopage ayant un premier type de conductivité dans un substrat semi-conducteur (1) ayant l'autre type de conductivité, à travers une couche d'oxyde (2) placée sur le substrat par l'intermédiaire d'une fenêtre (4) formée dans une couche de masquage (3) afin qu'une région de base (5) soit formée dans le substrat, l'enlèvement ultérieur d'une partie au moins de la couche exposée d'oxyde (2) et l'enlèvement de la couche de masquage (3), le dépôt d'une couche (6) de silicium polycristallin comprenant une couche unique sur la région de base (5) et la couche environnante d'oxyde (2), le dopage de la couche de silicium polycristallin (6) à l'autre type de conductivité, la délimitation d'une structure mesa (7) à partir de la couche (6) de silicium polycristallin dopée, cette structure mesa (7) recouvrant une partie de la région de base et comportant un émetteur de silicium polycristallin destiné au transistor bipolaire, l'exécution d'une opération d'oxydation pendant laquelle les parois latérales au moins (8) de la structure mesa (7) sont oxydées, l'implantation d'une matière de dopage du premier type de conductivité dans le substrat (1) afin qu'une région de contacts de base (12) soit formée dans le substrat au contact de la région de base (5), l'utilisation d'au moins une paroi latérale oxydée (8) de la structure mesa comme partie du masque d'implantation si bien que la région de contacts de base (12) est automatiquement alignée sur l'émetteur (7) de silicium polycristallin, la formation d'une région (13) de contacts de collecteur de l'autre type de conductivité dans le substrat (1), et la disposition de contacts électriques externes pour la région implantée de contacts de base (12), la région de contacts de collecteur (13) et l'émetteur (7) de silicium polycristallin.

2. Procédé selon la revendication 1, dans lequel la délimitation de la structure mesa comprend le masquage convenable de la couche (6) de silicium polycristallin et une attaque à sec.

3. Procédé selon la revendication 1 ou 2, comprenant en outre les étapes de délimitation d'au moins une structure mesa (14) d'alignement de contacts de silicium polycristallin dans la couche (6) de silicium polycristallin, la structure mesa (14) d'alignement étant placée sur la couche d'oxyde (2) et les parois latérales (17) de cette structure mesa d'alignement (14) étant oxydées pendant l'étape d'oxydation, et d'implantation de la région de contacts de collecteur (13) dans le substrat (1) à l'aide d'au moins une paroi latérale oxydée (17) de la structure mesa d'alignement (14) constituant une partie du masque d'implantation, si bien que l'espacement de l'émetteur (7) de silicium polycristallin et de la région de contacts de collecteur (13) est déterminé par la structure mesa d'alignement (14).

4. Procédé selon l'une quelconque des revendications précédentes, dans lequel la structure mesa (7) est disposée pratiquement au centre d'une surface de la région de base (5), et le procédé comprend une étape de formation de deux régions de contacts de base (12) placées de part et d'autre de la structure mesa (7) et alignées automatiquement sur celle-ci par des parois latérales oxydées respectives (8).

5. Procédé selon l'une quelconque des revendications précédentes, dans lequel une autre partie du masque d'implantation des régions de contacts de base est formée par une matière de réserve photographique (10).

**Patentansprüche**

1. Verfahren zur Herstellung eines Bipolartransistors, bei dem die Schaffung lediglich einer einzigen Schicht aus polykristallinem Silizium erforderlich ist, wobei das Verfahren die Ausführung der folgenden Schritte in der folgenden Reihenfolge umfaßt: Implantieren eines Dotierungsmittels eines Leitfähigigkeitstyps in ein Halbleitersubstrat (1) des entgegengesetzten Leitfähigkeitstyps durch eine darauf angeordnete Oxydschicht (2) hindurch über ein Fenster (4) in einer Maskierungsschicht (3), wodurch ein Basisbereich in dem Substrat geschaffen wird, nachfolgendes Entfernen zumindestens eines Teils der freiliegenden Oxydschicht (2) und Entfernen der Maskierungsschicht (3), Abscheiden einer die einzige Schicht bildenden polykristallinen Siliziumschicht (6) auf den Basisbereich (5) und die umgebende Oxydschicht (2), Dotieren der polykristallinen Siliziumschicht (6) mit dem entgegengesetzten Leitfähigkeitstyp, Ausbilden einer Mesa-Struktur (7) aus der dotierten polykristallinen Siliziumschicht (6), wobei die Mesa-Struktur (7) über einem Teil des Basisbereichs liegt, und einen polykristallinen Siliziumemitter für den bipolaren Transistor umfaßt, Ausführung eines Oxidationsverfahrens, während dessen zumindestens die Seitenwände (8) der Mesa-Struktur (7) oxidiert werden, Implantieren eines Dotierungsmittels des einen Leitfähigkeitstyps in das Substrat (1), wodurch in diesem ein mit dem Basisbereich (5) in Kontakt stehender Basiskontaktbereich (12) geschaffen wird, wobei zumindestens eine oxydierte Seitenwand (8) der Mesa-Struktur als Teil der Implantationsmaske verwendet wird, wodurch der Basiskontaktbereich (12) mit dem polykristallinen Siliziumemitter (7) selbstausgerichtet ist, Ausbilden eines Kollektor-Kontaktbereiches (13) des anderen Leitfähigkeitstyps in dem Substrat, und Schaffung externer elektrischer Kontakte an den im plantierten Basiskontaktbereich (12), den Kollektorbereich (13) und den polykristallinen Siliziumemitter (7).

2. Verfahren nach Anspruch 1, bei dem die Ausbildung der Mesa-Struktur eine geeignete Maskierung der polykristallinen Siliziumschicht (6) und trockenes Ätzen umfaßt.

3. Verfahren nach Anspruch 1 oder 2, das weiterhin die Schritte der Abgrenzung zumindestens einer polykristallinen Silizium-Kontaktausrichtungs-Mesa-Struktur (14) von der polykristallinen Siliziumschicht (6), wobei die Ausricht-Mesa-Struktur (14) auf der Oxydschicht (2) angeordnet ist und die Seitenwände (17) dieser Ausricht-Mesa-Struktur (14) während des Oxydationsverfahrens oxidiert werden, und die Implantation des Kollektor-Kontaktbereiches (13) in das Substrat (11) unter Verwendung von zumindestens einer oxidierten Seitenwand (17) der Ausricht-Mesa-Struktur (14) als Teil der Implantationsmaske einschließt, wodurch der Abstand zwischen dem polykristallinen Siliziumemitter (7) und dem Kollektor-Kontaktbereich durch die Ausricht-Mesa-Struktur (14) definiert ist.

4. Verfahren nach einem der vorhergehenden Ansprüche, bei dem die Mesa-Struktur (7) im wesentlichen mittig bezüglich einer Oberfläche des Basisbereiches (5) angeordnet ist, und das den Schritt der Ausbildung von zwei Basiskontaktbereiche (12) auf gegenüberliegenden Seiten der Mesa-Struktur (7) einschließt, die mit dieser durch die jeweiligen oxidierten Seitenwände (8) selbstausgerichtet sind.

5. Verfahren nach einem der vorhergehenden Ansprüche, bei dem ein anderer Teil der Basiskontaktbereichs-Implantationsmaske durch ein Fotoabdeckmaterial (10) gebildet ist.

# Fig.1.

$B^+$

# Fig.4.

# Fig.2.

# Fig.5.

# Fig.3.

# Fig.6.

$B^+$

# Fig.7.

$As^+$

$As^+$